(19) Europäisches Patentamt
European Patent Office
Office européen des brevets

(11) Veröffentlichungsnummer: **0 134 446**
**B1**

(12) **EUROPÄISCHE PATENTSCHRIFT**

(45) Veröffentlichungstag der Patentschrift: **20.05.87**

(51) Int. Cl.⁴: **C 09 B 29/085,** G 03 F 7/02

(21) Anmeldenummer: **84107368.7**

(22) Anmeldetag: **27.06.84**

# (54) Negativ arbeitende Fotoresistzusammensetzungen mit strahlungsabsorbierenden Zusätzen.

(30) Priorität: **09.07.83 DE 3324795**

(43) Veröffentlichungstag der Anmeldung: **20.03.85 Patentblatt 85/12**

(45) Bekanntmachung des Hinweises auf die Patenterteilung: **20.05.87 Patentblatt 87/21**

(84) Benannte Vertragsstaaten: **AT CH DE FR GB IT LI NL SE**

(56) Entgegenhaltungen:
**GB-A-422 843**
**US-A-4 268 603**
**US-A-4 287 289**

(73) Patentinhaber: **Merck Patent Gesellschaft mit beschränkter Haftung, Frankfurter Strasse 250, D-6100 Darmstadt (DE)**

(72) Erfinder: **Haas, Günther, Dr., Saarstrasse 109, D-6903 Neckargemünd (DE)**
Erfinder: **Neisius, Karl Heinz, Dr., Kattreinstrasse 76, D-6100 Darmstadt (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 134 446 B1

LIBER, STOCKHOLM 1987

**Beschreibung**

Die Erfindung betrifft neue Verbindungen der allgemeinen Formel I

(I) 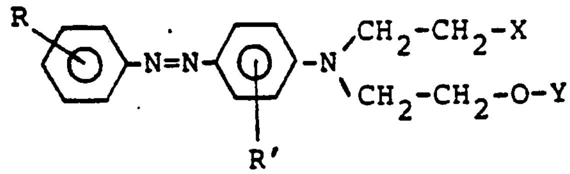

in der
R und R' = unabhängig voneinander Wasserstoff, Alkyl mit bis zu 4 C-Atomen oder Halogen,
X = Wasserstoff oder O-Y und
Y = Alkyl oder Acyl mit jeweils bis zu 4 C-Atomen oder gegebenenfalls substituiertes Aryl mit bis zu 10 C-Atomen
bedeuten sowie deren Verwendung als strahlungsabsorbierende Substanzen in negativ arbeitenden Fotoresistzusammensetzungen.

Negativ-Fotoresists werden heute in großem Maße bei der Herstellung von elektrischen Schaltungen und elektronischen Bauteilen verwendet. Insbesondere wird bei der Produktion von hoch- und höchstintegrierten Halbleiterschaltungen die Strukturierung der Leiter- bzw. Halbleitersubtrate durch fotografische Techniken mit Hilfe von Fotoresists vorgenommen.

Die heute üblichen Negativ-Fotoresistzusammensetzungen enthalten, gelöst in einem organischen Lösungsmittel, als wesentliche Komponenten cyclisierten Gummi sowie eine als Fotovernetzer wirkende lichtempfindliche Bisazido-Verbindung.

Gemäß den üblichen Verfahrensweisen werden die Substratoberflächen nach bekannten Methoden mit der Fotoresistzusammensetzung beschichtet und das Lösungsmittel durch Vortrocknen bei Temperaturen um etwa 100° C entfernt. Die Fotoresistschicht wird dann durch eine Negativvorlage bildmäßig mit im allgemeinen Ultraviolettstrahlung belichtet, wodurch, entsprechend dem Bildmuster, in den der Strahlung ausgesetzten Bereichen der Schicht durch die strahlungsempfindliche Bisazido-Verbindung eine Vernetzung des Polymermaterials hervorgerufen wird. Durch Behandlung mit einem als Entwickler dienenden Lösungsmittel werden die unbelichteten Teile der Schicht entfernt, wobei die unlöslichen strahlungsvernetzten Bildbereiche als Reliefstruktur auf der Substratoberfläche verbleiben.

Die hohe, noch immer weiter fortschreitende Miniaturisierung von mit Hilfe von Fotoresisttechniken hergestellten elektronischen Bauteilen stellt höchste Qualitätsanforderungen an die zur Anwendung gelangenden Fotoresistzusammensetzungen, insbesondere im Hinblick auf das zu erzielende Auflösungsvermögen sowie auf die Haftfestigkeit der Resistschicht auf dem Substrat.

Negativ-Fotoresists nach dem Stand der Technik entsprechen jedoch nicht in ausreichendem Maße diesen Qualitätsanforderungen. So wird etwa bei Anwendung derartiger Fotoresists auf Substraten, die eine Oberfläche mit hohem Reflexionsvermögen aufweisen - dies ist in der Regel bei Halbleitermaterialien und Metallen, wie beispielsweise Silizium, Aluminium, Kupfer, Chrom usw. der Fall - das Auflösungsvermögen des Fotoresists bei der Bestrahlung durch an der Oberfläche des Substrats auftretende Reflexionserscheinungen erheblich vermindert. Durch unregelmäßige Streuung des eingestrahlten Lichts an der Substratoberfläche dringt Streulicht in Bereiche der Resistschicht, die entsprechend dem Bildmuster der Negativvorlage keiner Strahlung ausgesetzt sein sollten. Durch die auch in diesen Bereichen ausgelöste Vernetzung des Polymermaterials werden nach der Entwicklung Reliefstrukturen mit erhöhter Linienbreite und verminderter Kantenschärfe erhalten. Feine und feinste Strukturen wie sie in der Mikroelektronik erzeugt werden sollen, sind durch diese Effekte nur noch mit eingeschränkter Wiedergabetreue erhältlich.

Versuche zur Lösung des geschilderten Problems sind bekannt.

So wird, z. B. in der japanischen Auslegeschrift Nr. 37562/76 vorgeschlagen, zur Verminderung dieser nachteiligen Effekte den Fotoresistzusammensetzungen auf Basis von cyclisiertem Gummi und lichtempfindlichen Bisazido-Verbindungen strahlungsabsorbierende Farbstoffe, insbesondere 4-N,N-Diethylaminoazobenzol zuzusetzen.

Die hier als Strahlungsabsorber genannten Verbindungen haben jedoch den Nachteil, daß sie bei Temperaturen bis 100° C, wie sie während des Vortrocknens zur Erzielung einer guten Haftfestigkeit der Resistechicht auf dem Substrat erforderlich sind, stark zur Sublimation neigen. Dadurch verringert sich die Konzentration dieser Substanzen in der Fotoresistschicht in solchem Maß daß unter diesen Bedingungen eine hohe und reproduzierbare Auflösung nicht erreicht werden kann.

Gleiches gilt für die Verbindungen der US-Patentschrift 4,287,289.

In der US-Patentschrift 4,268,603 werden Negativ-Fotoresistzusammensetzungen auf Basis von cyclisiertem Gummi und Bisazido-Verbindungen beschrieben, denen zur Vermeidung der geschilderten nachteiligen Effekte ein Gemisch aus strahlungsabsorbierenden und Fluoreszenzstrahlung emitierende Substanzen zugesetzt wird. Als Strahlungsabsorber sind hier Aminoazobenzol-Derivaten, unter anderem auch die Verbindung 4-N-Ethyl-N-(2-hydroxyethyl)-aminoazobenzol genannt. Diese komplizierten zusammengesetzen Fotoresists sollen eine hohe Wiedergabetreue des Resistbildes gewährleisten.

Es zeigt sich jedoch, daß die zur Anwendung gelangenden Strahlungsabsorber nicht in ausreichendem Maße in den Fotoresistformulierungen löslich sind, um dann in der Resistschicht in einer genügend wirksamen Konzentration vorzuliegen. Darüberhinaus wird beobachtet, daß sich bei der Beschichtung der Substrate und der nachfolgenden Trocknung Anteile des gelösten Farbstoffes in der Schicht als Festsubstanz kristallisierend ausscheiden.

Solche Resistmaterialien weisen demnach für die heutigen Erfordernisse noch Nachteile auf.

Es bestand somit die Aufgabe neue strahlugsabsorbierende Substanzen zu finden die die in Fotoresistbeschichtungen insbesondere auf stark reflektierenden Substraten auftretenden unerwunschten Streueffekte wirksam unterbinden. Diese Substanzen sollten in Negativ-Fotoresinstformulierungen ausreichend löslich sein und unter den Bedingungen des Vortrocknens zur Erhöhung der Haftfestigkeit bei Temperaturen um etwa 100°C sich nicht durch Verdampfen oder Sublimation aus der Resistbeschichtung verflüchtigen. Weitherhin sollten negativ arbeitende Fotoresistzusammensetzungen bereitgestellt werden, die diese strahlungsabsorbierenden Substranzen enthalten und die in bezug auf Auflösungsvermögen, Kantenschärfe und Haftfestigkeit den höchsten Qualitätsanforderungen entsprechen.

Diese Aufgabe wurde durch die Bereitstellung der obengenannten neuen Verbindungen der allgemeinen Formel I gelöst.

In der Britischen Patentschrift 422,843 wird die Herstellung von Azofarbstoffen des vorliegenden Substitutionstypus beschrieben, jedoch ohne die für die vorliegende Anwendung ausgewählten Verbindungen zu nennen oder Hinweise auf bestimmte, für die Verwendung in Fotoresists wichtige Eigenschaften zu geben.

Überraschend wurde gefunden, daß sich diese Verbindungen aufgrund ihrer guten Löslichkeit, ihrer geringen Flüchtigkeit und ihres Absorptionsverhaltens in hervorragender Weise als strahlungsabsorbierende Zusätze für negativ arbeitende Fotoresistzusammensetzungen eignen.

Gegenstand der Erfindung sind somit Verbindungen der allgemeinen Formel I.

Gegenstand der Erfindung ist weiterhin die Verwendung von Verbindungen der allgemeinen Formel I als strahlungsabsorbierende Substanzen in negativ arbeitenden Fotoresistzusammensetzungen.

Gegenstand der Erfindung sind darüberhinaus negativ arbeitende Fotoresistzusammensetzungen auf Basis von cyclisiertem Gummi und lichtempfindlichen Bisazido-Verbidungen, in denen die Verbindungen der allgemeinen Formel I als strahlungsabsorbierende Substanzen enthalten sind.

Die reste R und R' an den aromatischen Ringen sind in der Regel Wasserstoff, können aber auch jeweils Halogen, insbesondere Chlor und Brom, oder Alkyl mit bis zu 4 C-Atomen, wie Methyl, Ethyl, n-, i-Propyl, n-, i- und t-Butyl sein und beliebige der noch freien Ringpositionen einnehmen.

Für die Reste X und Y der Substituenten am Aminostickstoff gilt, daß X Wasserstoff oder die Gruppierung O-Y darstellt. Y steht für die im vorangegangenen aufgezählten Alkylgruppen mit biz zu 4 C-Atomen oder für Acylgruppen mit ebenfalls biz zu 4 C-Atomen, wie beispielsweise Acetyl, Propionyl, Butyryl oder für Aryl bzw. substituiertes Aryl mit bis zu 10 C-Atomen. Letzteres kann beispielsweise sein: Phenyl, alkylsubstituiertes Phenyl wie Tolyl oder Naphthyl. Bevorzugt für die Verwendung als Strahlungsabsorber in Negativ-Fotoresists sind Verbindungen mit R und R' = Wasserstoff, in denen X Wasserstoff oder O-Y und O-Y Ethoxy Acetoxy oder Phenoxy ist.

Besonders bevorzugt sind die Verbindungen:

4-N-Ethyl-N-(2-phenoxyethyl)-aminoazobenzol

4-N, N-Bis(2-ethoxyethyl)-aminoazobenzol

4-N, N-Bis(2-acetoxyethyl)-aminoazobenzol.

Die Verbindungen der Formel I werden in einfacher Weise und nach bekannten Methoden durch Diazoltieren von Anilin und Umsetzung der Diazoniumverbindung mit entsprechend N-substituierten Anilin-Derivaten hergestellt. Die N-substituierten Anilin-Derivaten sind entweder im Handel erhältlich oder durch N-Substitution von Anilin leicht herstellbar.

Alle Verbindungen gemäß der allgemeinen Formel I absorbieren Strahlung im Wellenlängenbereich zwischen 350 und 450 nm und besitzen Absorptionsmaxima, inbesondere im Berieich zwischen 400 und 420 nm. Aufgrund dieser Absorptionseigenschaften eignen sich diese Substanzen sehr gut als absorbierende Zusätze für Negativ-Fotoresists, um Streueffekte in Resistbeschichtungen auf stark reflektierenden Substraten bei der Struktuirerung mit Ultraviolettlicht dieses Wellenlängenbereichts zu unterbinden.

Als Negativ-Fotoresistzusammensetzungen sind solche zu verstehen, die als wesentliche Komponenten cyclisierten Gummi sowie als Fotovernetzer wirkende lichtempfindliche Bisazido-Verbindungen, gelöst in einem organischen Lösungsmittel, wie etwa Xylol, enthalten. Entsprechende Komponenten sind zur Genüge bekannt und werden gemeinhin in Fotoresists nach dem Stand der Technik eingesetzt. Die mit der Bezeichnung cyclisierter Gummi umschriebene Stoffklasse umfaßt Polymermaterialien, wie cyclisiertes Polyisopren, cyclisiertes Polyisobutylen, cyclisiertes Polybutadien und ähnliche. Bevorzugt sind Polymermaterialien auf Basis von cyclisiertem Polyisopren.

Die als Fotovernetzer dieneden lichtempfindlichen Substanzen sind aromatische Bisazido-Verbindungen, wie sie beispielsweise in den US-Patenschriften 2,852,379 und 2,940,853 sowie in der Deutschen Patentanmeldung 32 34 301 beschrieben sind. Die weitaus größte technische Bedeutung hat erlangt die Verbindung 2,6-Bis-[(4-azidophenyl) methylen]-4-methylcyclohexanon die deshalb besonders bevorzugt ist.

In Resistzusammensetzungen mit den genannten Hauptkomponenten sind die Verbindungen der Formel I in

mehr als ausreichendem Maße löslich, um in der Resistbeschichtung in genügend wirksamer Konzentration vorzuliegen. Im Gegensatz zu Strahlungsabsorbern nach dem Stand der Technik kristallisieren diese Verbindungen bei der Beschichtung der Substrate und während der Trocknung nicht aus.

Der besondere Vorteil der erfindungsgemäßen Strahlungsabsorber ist, daß sich diese unter den Bedingungen des Vortrocknens bei Temperaturen um etwa 100°C praktisch nicht aus der Resistschicht durch Verdunsten bzw. Sublimation verflüchtigen. Selbst bei Temperaturen von 120°C und Trocknungszeiten von über 2 Stunden bleibt die Konzentration der erfindungsgemäßen Verbindungen in der Schicht bemerkenswert konstant.

Der Vorgang des Vortrocknens bei diesen Temperaturen ist deshalb von besonderer Wichtigkeit, weil hierdurch der Resistschicht eine erhöhte Haftfestigkeit auf dem Substrat verliehen wird. Dies ist bei den heutigen Herstellungsverfahren für hoch miniaturisierte elektronische Schaltungen unerläßlich.

In den erfindungsgemäßen Fotoresistzusammensetzungen können diese neuen strahlungsabsorbierenden Substanzen in einem Anteil von 0,1 bis 7, vorzugsweise von 0,5 bis 4 Gewichtsprozent, bezogen auf die Menge an cyclisiertem Gummi, enthalten sein.

In diesem Konzentrationsbereich verhindern sie sehr wirksam praktisch jegliche Lichtstreuung in der Resistschicht bei der Bestrahlung von mit den erfindungsgemäßen Fotoresistmaterialien beschichteten Substraten.

Durch die vorliegende Erfindung können somit auch auf stark reflektierenden Substraten Fotoresistreliefstrukturen von höchster Qualität hinsichtlich Auflösungsvermögen, Kantenschärfe und Haftfestigkeit erhalten werden.

**Beispiel 1:**

Herstellung von 4-N-Ethyl-N-(2-phenoxyethyl)-aminoazobenzol (Substanz 1).

5,2 g Anilin werden in schwefelsaurer-wässriger Lösung in üblicher Weise mit 4,1 g Natriumnitrit diazotiert; die erhaltene Diazoniumsalzlösung wird mit 50 ml Ethanol verdünnt. Diese Lösung wird bei 5 - 10°C zu einer Lösung von 13,9 g N-Ethyl-N-(2-phenoxyethyl)-anilinhydrochlorid in 50 ml 50 %igem Ethanol zugetropft. Anschließend wird der pH-Wert der Reaktionsmischung mit 2 n Natronlauge auf 4 eingestellt und weitere 50 ml Ethanol zugegeben.

Man rührt bei 0 - 5°C, wobei der pH-Wert auf ca. 3 absinkt. Durch erneute Zugabe von 2 n Natronlauge wird wieder auf pH 4 eingestellt und das ausgefallene Produkt abgesaugt, mit Wasser gewaschen und getrocknet. Nach Umkristallisieren aus Isopropanol oder nach chromatographischer Aufreinigung erhält man dunkelgelbe Kristalle vom Fp. 85 - 86°C.

Analog werden hergestellt:

>4-N,N-Bis(2-ethoxyethyl)-aminoazobenzol (Substanz 2)

4-N,N-Bis(2-acetoxyethyl)-aminoazobenzol (Substanz 3).

**Beispiel 2:**

Bestimmung der Sublimationsneigung.

Jeweils 10 g cyclisiertes Polyisopren werden in 90 g Xylol gelöst und mit jeweils 0,3 g Substanz 1, 2, 3, und 4-N,N-Diethylaminoazobenzol (Vergleichssubstanz 4) versetzt. Mit den so erhaltenen Lösungen wird jeweils eine Quarzscheibe beschichtet.

Mit 4-N-Ethyl-N-(2-hydroxyethyl)-aminoazobenzol (Vergleichssubstanz 5) läßt sich keine vergleichbare Resistformulierung herstellen, da nach Filtration der Resistlösung ca. 0,1 g Substanz ungelöst zurückbleiben.

Als Maß für die Sublimationstendenz der in der Resistschicht enthaltenen Absorbersubstanzen dienen die Extinktionswerte im jeweiligen Absorptionsmaximum (408-412 nm), gemessen nach unterschiedlicher Trocknungsdauer bei erhöhten Temperaturen und in prozentualen Vergleich gesetzt mit dem Ausgangswert.

| Trocknungs-bedingungen | Extinktion der Resistschicht, enthaltend Subst. 1 | 2 | 3 | 4 |
|---|---|---|---|---|
| 80°C, 30 min. | 100 % | 100 % | 100 % | 95 % |
| 80°C, 150 min. | 100 % | 100 % | 100 % | 75 % |
| 100°C, 30 min. | 100 % | 100 % | 98 % | 90 % |
| 100°C,150 min. | 100 % | 95 % | 90 % | 60 % |
| 120°C, 30 min. | 100 % | 95 % | 95 % | 81 % |
| 120°C,150 min. | 100 % | 85 % | 78 % | 50 % |

**Beispiel 3:**

Herstellung von negativen Reliefbildern.

Mit einer lichtempfindlichen Zusammensetzung aus jeweils 10 g cyclisiertem Polyisopren, 90 g Xylol, 0,4 g 2,6 Bis-[(4-azidophenyl)methylen]-4-methylcyclohexanon und

A) 0,3 g Substanz 1

B) 0,3 g Substanz 2

C) 0,3 g Substanz 3

D) 0,3 g Vergleichssubstanz 4

E) 0,3 g Vergleichssubstanz 5+

wird je ein Silizium-Wafer, der zuvor an der Oberfläche mit einer 0,2 µm starken Aluminiumschicht versehen wurde, beschichtet.

(+Nach Filtration der Resistlösung bleiben ca. 0,1 g Substanz ungelöst zurück; Feststoffausschiedungen in der Schicht; unbrauchbar.)

Nach der Trocknung (20 min., 100°C) werden die erhaltenen lichtempfindlichen Schichten (Schichtdicke 1 µm) durch eine Auflösungsprüfmaske aus Chrom bildmäßig belichtet. Die Entwicklung erfolgt durch Behandlung mit einer handelsüblichen Entwicklerlösung für 50 sec.

| lichtempfindliche Zusammensetzung | Auflösungs-vermögen | Haftfestigkeit |
|---|---|---|
| A | 1,8 µm | gut |
| B | 2,1 µm | gut |
| C | 2,0 µm | gut |
| D | 2,6 µm | mäßig (Trocknung bei 85°C) |
| E | ./.++ | gut |

+ Nach Filtration der Resistlösung bleiben ca. 0,1 g Substanz ungelöst zurück; Feststoffausscheidungen in der Schicht; unbrauchbar.

**Patentansprüche**

für die Vertragsstaaten CH, DE, FR, GB, IT, LI, NL, SE

1. Verbindungen der allgemeinen Formel I

(I) 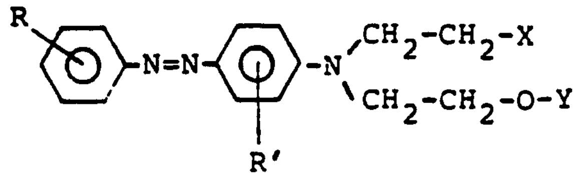

in der

R und R' = unabhängig voneinander Wasserstoff, Alkyl mit bis zu 4 C-Atomen oder Halogen,

X = Wasserstoff oder O-Y und

Y = Alkyl oder Acyl mit jeweils bis zu 4 C-Atomen oder gegebenenfalls substituiertes Aryl mit bis zu 10 C-Atomen

bedeuten.

2. Verwendung von Verbindungen der allgemeinen Formel I nach Anspruch 1 als strahlungsabsorbierende Substanzen in negativ arbeitenden Fotoresistzusammensetzungen.

3. Negativ arbeitende Fotoresistzusammensetzungen auf Basis von cyclisiertem Gummi und lichtempfindlichen Bisazidoverbindungen, dadurch gekennzeichnet, daß darin Verbindungen der allgemeinen Formel I nach Anspruch 1 als strahlungsabsorbierende Substanzen enthalten sind.

4. Fotoresistzusammensetzungen nach Anspruch 3, dadurch gekennzeichnet, daß darin die Verbindungen der Formel I nach Anspruch 1 in einem Anteil von 0,1 - 7 Gew.-%, vorzugsweise 0,5 - 4 Gew.-%, bezogen auf die Menge an cyclisiertem Gummi, enthalten sind.

**Patentansprüche**

für den Vertragsstaat AT

1. Verwendung von Verbindungen der allgemeinen Formel I

(I) 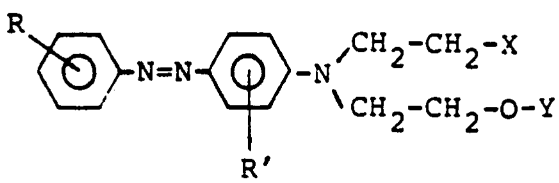

in der

R und R' = unabhängig voneinander Wasserstoff, Alkyl mit bis zu 4 C-Atomen oder Halogen,

X = Wasserstoff oder O-Y und

Y = Alkyl oder Acyl mit jeweils bis zu 4 C-Atomen oder gegebenenfalls substituiertes Aryl mit bis zu 10 C-Atomen

bedeuten,

als strahlungsabsorbierende Substanzen in negativ arbeitenden Fotoresistzusammensetzungen.

2. Negativ arbeitende Fotoresistzusammensetzungen auf Basis von cyclisiertem Gummi und lichtempfindlichen Bisazidoverbindungen, dadurch gekennzeichnet, daß darin Verbindungen der allgemeinen Formel I nach Anspruch 1 als strahlungsabsorbierende Substanzen enthalten sind.

3. Fotoresistzusammensetzungen nach Anspruch 2, dadurch gekennzeichnet, daß darin die Verbindungen der Formel 1 nach Anspruch 1 in einem Anteil von 0,1 - 7 Gew.-%, vorzugsweise 0,5 - 4 Gew.-%, bezogen auf die Menge an cyclisiertem Gummi, enthalten sind.

**Claims**

for the Contracting States CH, DE, FR, GB, IT,LI, NL, SE

1. Compounds of the general formula I

(I) 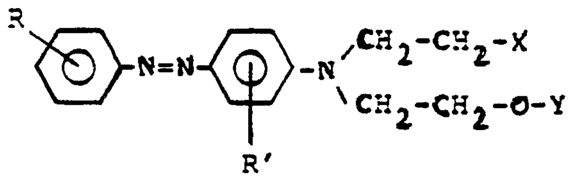

in which R and R' independently of one another denote hydrogen, alkyl with up to 4 C atoms or halogen, X denotes hydrogen or O-Y and Y denotes alkyl or acyl with in each case up to 4 C atoms or optionally substituted aryl with up to 10 C atoms.

2. Use of compounds of the general formula I according to claim 1 as radiation-absorbing substances in negatively operating photoresist compositions.

3. Negatively operating photoresist compositions based on cyclised rubber and photosensitive bisazido compounds, characterised in that they contain compounds of the general formula I according to claim 1 as radiation-absorbing substances.

4. Photoresist compositions according to Claim 3, characterised in that they contain the compounds of the formula I according to claim 1 in an amount of 0.1 - 7% by weight, preferably 0.5 - 4% by weight, based on the amount of cyclised rubber.

**Claims**

for the Contracting State AT

1. Use of compounds of the general formula I

(I) 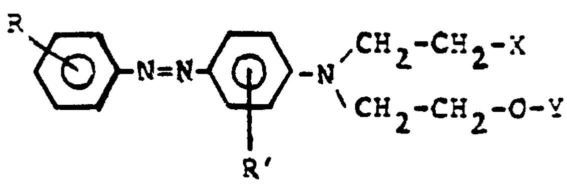

in which R and R' independently of one another denote hydrogen, alkyl with up to 4 C atoms or halogen, X denotes hydrogen or O-Y and Y denotes alkyl or acyl with in each case up to 4 C atoms or optionally substituted aryl with up to 10 C atoms, according to claim 1 as radiation-absorbing substances in negatively operating photoresist compositions.

2. Negatively operating photoresist compositions based on cyclised rubber and photosensitive bisazido compounds, characterised in that they contain compounds of the general formula I according to claim 1 as radiation-absorbing substances.

3. Photoresist compositions according to Claim 2, characterised in that they contain the compounds of the formula I according to claim 1 in an amount of 0.1 - 7% by weight, preferably 0.5 - 4% by weight, based on the amount of cyclised rubber.

**Revendications**

pour les Etats contractants CH, DE, FR, GB, IT, LI, NL, SE

1.- Composés de formule générale I :

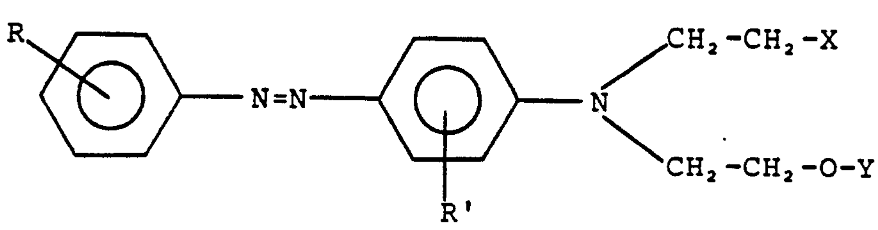 I

dans laquelle:

R et R' représentent chacun, indépendamment l'un de l'autre, l'hydrogène, un groupe alkyle contenant jusqu'à 4 atomes de carbone ou un halogène,

X représente l'hydrogène ou le groupe O-Y et

Y représente un radical alkyle ou acyle contenant chacun jusqu'à 4 atomes de carbone ou un radical aryle éventuellement substitué contenant jusqu'à 10 atomes de carbone.

2.- Utilisation des composés de formule générale I selon la revendication 1, en tant que substances absorbant les radiations dans des compositions de photorésists opérant en négatif.

3.- Compositions de photorésists opérant en négatif, à base de caoutchouc cyclisé et de composés photosensibles du type bis-azide, caractérisées en ce qu'elles contiennent en tant que substances absorbant les radiations des composés de formule générale I selon la revendication 1.

4.- Compositions de photorésists selon la revendication 3, caractérisées en ce qu'elles contiennent les composés de formule I selon la revendication 1 en proportions de 0,1 à 7 % en poids, de préférence de 0,5 à 4 % en poids, par rapport à la quantité de caoutchouc cyclisé.

**Revendications**

pour l'Etat contractant AT

1.- Utilisation de composés de formule générale I:

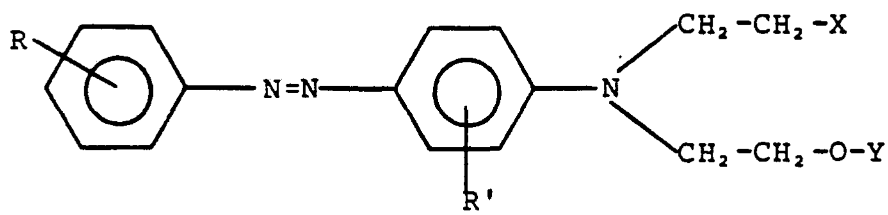

I

dans laquelle

R et R' représentent chacun, indépendamment l'un de l'autre l'hydrogène, un groupe alkyle contenant jusqu'à 4 atomes de carbone ou un halogène,

X représente l'hydrogène ou le groupe O-Y et

Y représente un radical alkyle ou acyle contenant chacun jusqu'à 4 atomes de carbone ou un radical aryle éventuellement substitué contenant jusqu'à 10 atomes de carbone,

en tant que substances absorbant les radiations dans des compositions de photorésists opérant en négatif.

2.- Compositions de photorésists opérant en négatif, à base de caoutchouc cyclisé et de composés photosensibles du type bis-azide, caractérisées en ce qu'elles contiennent des composés de formule générale I selon la revendication 1 en tant que substances absorbant les radiations.

3.- Compositions de photorésists selon la revendication 2, caractérisées en ce qu'elles contiennent les composés de formule I selon la revendication 1 en proportions de 0,1 à 7 % en poids, de préférence de 0,5 à 4 % en poids, par rapport à la quantité de caoutchouc cyclisé.